Europäisches Patentamt

European Patent Office

Office européen des brevets

(19)

(11) Publication number: **0 252 888**
**A2**

(12) **EUROPEAN PATENT APPLICATION**

(21) Application number: 87830242.1

(22) Date of filing: 26.06.87

(51) Int. Cl.³: **H 01 L 21/308**
**H 01 L 21/306**

(30) Priority: 30.06.86 IT 4820686

(43) Date of publication of application:
13.01.88 Bulletin 88/2

(84) Designated Contracting States:
DE FR GB NL SE

(71) Applicant: SELENIA INDUSTRIE ELETTRONICHE
ASSOCIATE S.p.A.
Via Tiburtina, KM 12.400
I-00131 Roma(IT)

(72) Inventor: Cetronio, Antonio
Via di Villa Taverna, 28
I-00400 Monte Porzio Roma(IT)

(72) Inventor: Moretti, Sergio
Via Polverigi, 43
I-00100 Rome(IT)

(72) Inventor: Patrizio, D'Eustacchio
Via Giovanni Giolitti, 401
I-00185 Rome(IT)

(74) Representative: Emiliani, Gabriele, Ing.
c/o ITALPATENT Via Agri, 3
I-00198 Roma(IT)

(54) Photopolymer multilayer structure for the production of a GaAs self aligning double recess.

(57) Technological process for the production of a GaAs self aligning double recess to be applied to power MESFET devices.

The process consists of a first exposure of the planarizing layer to define the length of the first recess, into which the gate is set and is followed by a second exposure of the same photopolymer to define the length of the second recess.

The resulting double recess structure, through suitable dimensioning, related to the active channel doping, gives way to high power MESFET devices; in particular it makes possible the application of high source to drain voltages ($V_{DS}$ typically $60 \div 80$ V) to the device before breakdown processes are triggered.

*fig. 1*

EP 0 252 888 A2

PHOTOPOLYMER MULTILAYER STRUCTURE FOR THE PRODUCTION OF A GaAs SELF ALIGNING
DOUBLE RECESS

This invention regards a Multilayer Resist Structure for the production of a double self aligning recess in GaAs, generally for power planar devices. It is, as a matter of fact, on GaAs planar power devices that high electric field areas arise around gate (2), due to Guun efect, and around drain (3), due to the forward shift of the depletion area, at interface (6) between active layer (4) and buffer layer (5), with increasing source to drain voltage $V_{DS}$. Clearly, from an operating viewpoint these high electric field areas imply a low burnthrough voltage reating for the device, which in turn results in a performance limitation.

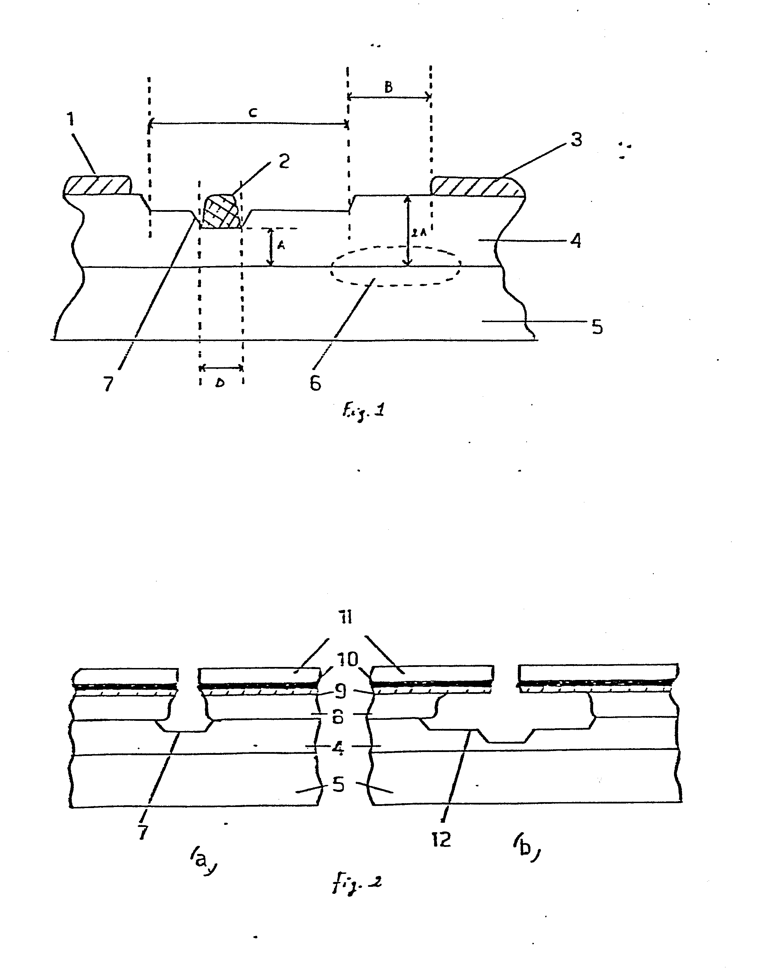

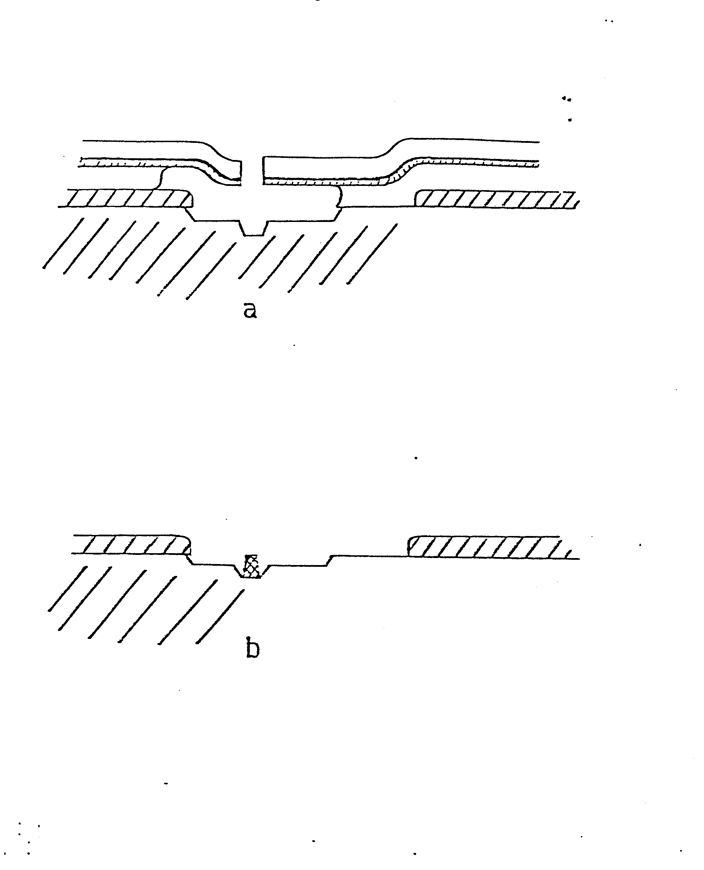

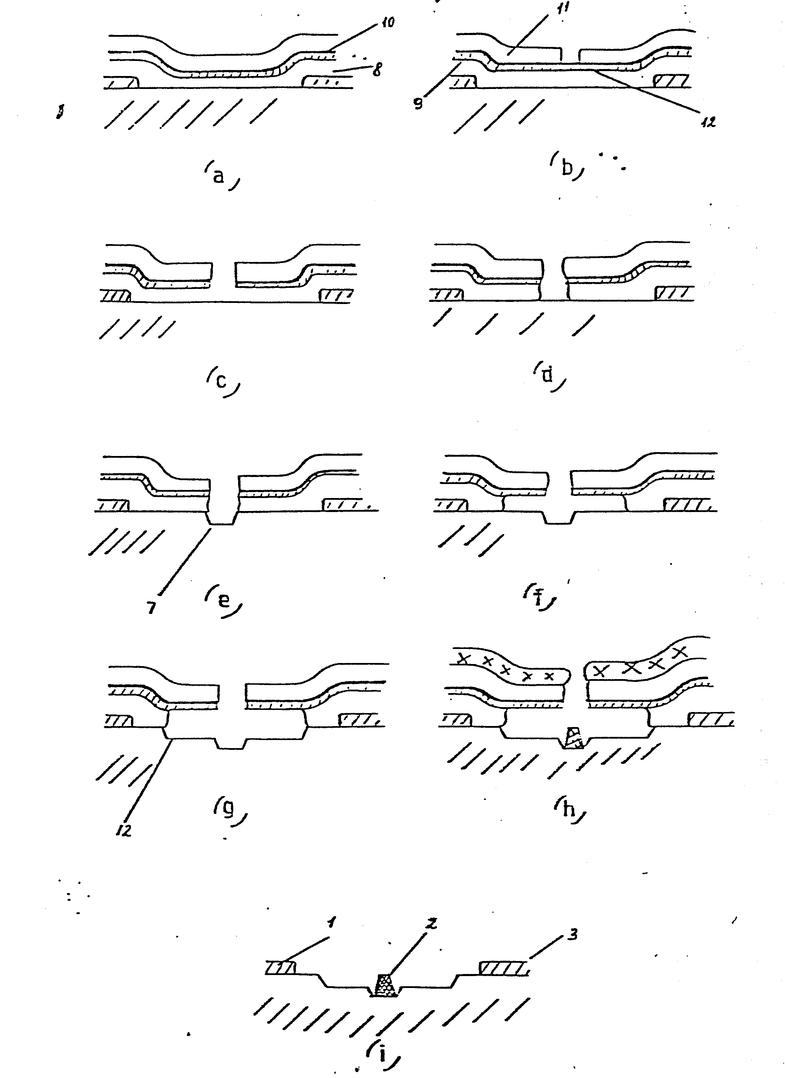

To eliminate these limitations, Tiwari et Al [1] and [2] have proposed a double recess structure as shown schematically in Figure 1, where the electric field around drain (3) is reduced by increasing the thickness of active layer (4) close to drain (3); while the electric field around gate (2) is reduced by recessing it (7) suitably.

This invention regards a technique through which the double recess structure mentioned can be produced by means of a photopolymer (1) multilayer structure. In particular this technique includes a first exposure of the planarising layer to define length D of the recess (7) for gate (2) and then a second exposure of the same. photopolymer to define length C of the second recess.

Such structure, which can be produced in a reliable and high yield manner adopting the technique described in this patent application, with demensions A,B,C, and D optimised as a function of active channel doping, makes possible to apply source-drain voltages to the device of the order of 60 - 80 V, and therefore it gives way to high power ratings of the device.

It is worthwhile to mention that one of the advantages brought about by the process herein presented, is that of being applicable to any substrata, albeit the description presented deals preferably with GaAs.

The invention will now be described with reference to one of its presently preferred forms, which is reported for illustrative but non limiting reasons and based upon the tables enclosed:

Figure 1 shows schematically a double recess structure as applied to a power MESFET. Here

(1) is the MESFET source;

(2) is the MESFET gate;

(3) is the drain;

(4) is the MESFET active layer;

(5) is the semi isolating layer;

(6) is the interface depleted area;

active semi isolating layer;

(7) first recess close to the gate.

Figure 2 shows schematically the production process of the two self aligned recesses. Here:

(8) is the planarising photopolymer layer;

(9) Alluminium thin film;

(10) Gold thin film

(11) etching photopolymer layer;

(12) second recess self aligned with the first (7).

Figure 3 shows the details of the production phases of the self aligning double recess structure starting with phase (a) in which planarising photopolymer layer (8) is visible , as are the two metals Al (9) and Au (10) and the etching photopolymer (11) layer, following through to the last stage pf the process (i) in which, within the structure obtained, the self aligning double recess is visible, respectively: source (1), gate (2) and drain (3).

Figure 4 shows a schematic illustration of how the source is utilized to produce an asymmetrical double recess:

a) lithographic structure

b) asymmetrical recess.

The invention will now be described with reference to a MLR[1] structure. Patent Application N° 47648 A|86 âtd 13|02|86 in the name of the same company

Selènia to achieve a GaAs self aligning double recess for high performance power MESFETS; clearly such application is reported only as an illustration, without limiting the invention.

As shown in Figure 2 the main characteristics of the invention include:

1) the production of the MLR structure as per the previously mentioned patent application;

2) a first exposure of the planarising photopolymer (8) which, after development, determines the length of first recess (7);

3) erosion of GaAs through suitable chemical solution, to determine recess (7) (see figure 2a);

4) a second exposure of the planarising photopolymer (8) to determine the length of the second recess (12);

5) further erosion of GaAs to define the second recess (12) (see figure 2b).

Through this technique, the length of the two recesses is set accurately by suitable control of the exposure and development times of the planarising photopolymer; furthermore, the fact that the structure is self aligning gives a large advantage from the process reproducibility viewpoint.

The details of the production phases required to obtain the self aligning double recess on GaAs, shown in Figure 1, will now be presented with reference to the schematics shown in Figure 3.

As shown in Figure 3a, the first phase is that of producing the photopolymer multilayer structure (MLR) as described in Patent [1] mentioned above, after which the main steps required to outline the self aligning double recess are as follows:

(a) Exposure of layer (11) through a suitable stencil and following development to define aperture (12) of gate (2) as shown in figure 3b.

(b) With the etching layer used as a stencil, erode the Au layer (10) through ion milling and Al layer (9) through wet agent as shown in figure 3c.

(c) with the etching layer and gold layer used as stencil, the planarising layer (8) is exposed and developed so as to achieve a final structure as shown in figure 3d.

As the amount of under-erosion of the planarising layer, up to certain extent, is almost proportional to the photopolymer exposure time [1], this implies that the length of the first recess (7) may be set through a suitable exposure time of the photopolymer

(d) with the whole MLR structure as a stencil, first recess (7), is produced (see figure 3c) for gate (2) through suitable wet attack of GaAs (such as $H_2O_2+NH_4OH+H_2O$).

(e) make a second exposure of planarizing layer (8) to determine, after development, the length of second recess (12) as shown in figure 3f.

(g) subject GaAs to further erosion to define second recess (12) as shown in figure 3g.

Clearly, the depth of each recess is set during the design phase of the device.

(g) Using the whole MLR as stencil, gate (2) of the device is deposited through lift-off technique, as shown in figure 3h.

(h) Removal of the entire MLR structure by acetone lift off, leaving, on the GaAs substrate, gate (2) recessed in other self aligning recess set between source (1) and drain (3) of the device.

While presenting in detail the various production phases of the invention, for clarity, a situation where gate (2) is set at the center of the source-drain (3) channel has been taken into consideration.

However, it must be said that the invention is also valid in those cases in which the gate is offset toward the source, as in the case of power MESFETS. In fact, as shown in Figure 4a, in this case, metallisation (1) acts as a template on the source side and this gives way to a second recess (12) of the type shown in figure 4b, quite similar to the one foreseen by Tiwari et Al [2].

Therefore this invention regards a technique which exploits an MLR photopolymer structure along the lines of invention [1] achieving a self aligning double recess on GaAs,applicable to power MESFETS.

In particular, this technique includes a first exposure of the planarizing layer to define the length of the first recess, into which the gate is deposited, and then a further exposure of the same photopolymer to define the length of the second recess. The length of the two recesses are determined accurately through suitable control over exposure and development times of the planarizing photopolymer. Furthermore, as the structure is self aligning over the gate recess, it provides greater flexibility on the final shape of the double recess, i.e. with gate offset toward the source, the metal coating of the latter may be used as a stencil during GaAs erosion to outline the second recess, giving way to an asymmetrical channel structure (see figure 4b) as is required for power MESFETS.

Such double recess structure, with channel dimensions optimized to the active layer doping, provides a production method of MESFET devices which have remarkable power handling characteristics; in particular its adoption makes possible to apply high source to drain voltages ($V_{DS}$ typically between 60 and 80 V) to the device before burnthrough or damage eusues.

Bibliography

[1] Multi layer photopolymer structure (MLR) for the production of MESFET devices having submicrometic gates and variable length recessed channel. A. Cetronio, S. Moretti & V. Compagnucci, Italian Patent N. 47648 A/86.

[2] Physical and materials limitations on Burnout Voltage of GaAs power A MESFET$_s$
S. Tiwari, L.F. Eastman and L. Ralhbun; IEEE Trans. Elec. Devices, Vol ED27(6), (1980).

6

0252888

CLAIMS

1. Photopolymer multilayer structure for the production of a self aligning
double recess characterized by the following process:

a) exposure of planarizing photopolymer (8) to set the length of <u>first recess</u>
(7);

b) substrate (such as GaAs) erosion through suitable chemical solution (such
as $NH_4OH-H_2O_2-H_2O$);

c) further exposure of planarizing photopolymer (8) to set the length of the
<u>second recess</u> (12);

d) further erosion of the substrate (such as GaAs) by means of a suitable
solution (such as $NH_4OH-H_2O_2-H_2O$) to produce the <u>second recess</u> (12).

2. Photopolymer multilayer structure to produce a double recess, as per claim
1, where such process may be applied to any type of substrate.

3. Photopolymer multilayer structure, as per claim 1 & 2, characterized by
the fact that among the many applications of the process, such as in the case
of MESFET devices, it is possible to produce and therefore utilize an asymmetrical
double recess.

4. Photopolymer multilayer structure to produce a self aligning double recess,
characterized by the fact that it may be produced by a Multilayer Resist
structure as determined by Patent Application N. 47648 A/86.

1/3

0252888

Fig. 1

Fig. 2

0252888

a

b

(a)

(b)

(c)

(d)

(e)

(f)

(g)

(h)

(i)